# EUROPEAN PATENT APPLICATION

(11) **EP 4 372 831 A1**
(43) Date of publication of application: **22.05.2024**
(21) Application number: 22842468.5
(22) Date of filing: 13.07.2022
(51) Int. Cl.: H01L 33/58, H01L 33/48, H01L 33/62, H01L 33/40, H01L 33/54

(54) **LIGHT-EMITTING PACKAGE**

(30) Priority: 14.07.2021 US 202163221687 P
(71) Applicant: Seoul Viosys Co., Ltd., Ansan-si, Gyeonggi-do 15429 (KR)
(72) Inventor: MIN, Seung Gu, Ansan-Si Gyeonggi-do 15429 (KR); PARK, Eun Ji, Ansan-Si Gyeonggi-do 15429 (KR)
(74) Representative: Stolmár & Partner Patentanwälte PartG mbB
(86) International application number: PCT/KR2022/010234
(87) International publication number: WO 2023/287206

(57) **Abstract**

The present invention relates to a light emitting package. A light emitting package according to an embodiment of the present invention may include a body, a light emitting diode chip, and a light transmission member. The body includes a cavity open at an upper side thereof and may be formed of a ceramic material. The light emitting diode chip is mounted in the cavity of the body and may generate and emit UV light. The light transmission member may be disposed on top of the body to cover the cavity. In addition, the light transmission member may include a light transmission layer formed of sapphire and a light loss prevention layer formed on at least one surface of the light transmission layer. The light loss prevention layer may include a lower light loss prevention layer formed on a lower surface of the light transmission layer. The light emitting diode chip and the light transmission member may be spaced apart from each other to form a space therebetween. UV light emitted from the light emitting diode chip may sequentially pass through an air layer, the lower light loss prevention layer, and a sapphire layer so as to be emitted from the light emitting package.

## Description

### [Technical Field]

The present invention relates to a light emitting package.

### [Background Art]

A light emitting diode is an inorganic semiconductor device that emits light generated through recombination of electrons and holes. In recent years, light emitting diodes have been used in many applications, such as display devices, vehicular lamps, and general lighting.

Light emitting diodes have longer lifespan, lower power consumption, and faster response than typical light sources. With such advantages, light emitting diodes are rapidly replacing existing light sources.

A light emitting diode on a chip scale (hereinafter referred to as a light emitting diode chip) may be mounted on ceramic, white silicone, a substrate, or the like for packaging. The light emitting diode chip may be provided at an upper portion thereof with a light transmission member acting as a lens.

Generally, a lens for light emitting packages is formed of quartz in consideration of cost and light transmittance. However, quartz has low strength and can be easily broken by external impact.

Therefore, light emitting packages with quartz lenses have a problem of low reliability.

The above information disclosed in the background art is intended only to provide an understanding of the background of the concept of the present invention and thus may include information that does not constitute the prior art.

### [Disclosure]

### [Technical Problem]

It is an aspect of the present invention to provide a light emitting package achieving improvement in both reliability and light extraction efficiency.

### [Technical Solution]

In accordance with one aspect of the present invention, there is provided a light transmission member including a body, a light emitting diode chip, and a light transmission member.

The body includes a cavity open at an upper side thereof and may be formed of a ceramic material.

The light emitting diode chip may be mounted in a cavity of the body and may generate and emit UV light.

The light transmission member may be disposed on top of the body to cover the cavity. In addition, the light transmission member may include a light transmission layer formed of sapphire and a light loss prevention layer formed on at least one surface of the light transmission layer.

The light loss prevention layer may include a lower light loss prevention layer formed on a lower surface of the light transmission layer.

The light emitting diode chip and the light transmission member may be spaced apart from each other to form a space therebetween.

UV light emitted from the light emitting diode chip may sequentially pass through an air layer, the lower light loss prevention layer, and a sapphire layer so as to be emitted from the light emitting package.

The body may include a circuit formed therein. The circuit may be partially exposed to the cavity of the body and may be electrically connected to the light emitting diode chip.

The light emitting diode chip may include an electrode formed of a conductive metallic material at a lower side thereof. The electrode of the light emitting diode chip may be electrically connected to the circuit exposed to the cavity of the body.

The light emitting package may have a structure in which a ceramic layer, a metal layer, a UV light generation layer, the air layer, the light loss prevention layer, and the sapphire layer are placed sequentially from the bottom to the top.

In one embodiment, the lower light loss prevention layer may have a single-layer structure.

The lower light loss prevention layer may be formed of magnesium fluoride (MgF₂).

In another embodiment, the lower light loss prevention layer may include a plurality of layers.

At least one of the plurality of layers of the lower light loss prevention layer may be formed of magnesium fluoride (MgF₂). In addition, at least one of the other layers may be formed of hafnium oxide.

The light emitting package may further include an adhesive member disposed between the body and the light transmission member.

The adhesive member may be formed of silica (SiO₂) or strontium (Sr₄).

The light emitting package may further include a sealing member formed on an upper surface of the body.

The sealing member may be formed through metallization.

The light transmission member may further include an upper light loss prevention layer formed on an upper surface of the light transmission layer.

In one embodiment, the upper light loss prevention layer may have a single-layer structure.

The upper light loss prevention layer may be formed of magnesium fluoride (MgF₂).

In another embodiment, the upper light loss prevention layer may include a plurality of layers.

At least one of the plurality of layers of the upper light loss prevention layer may be formed of magnesium fluoride (MgF₂). In addition, at least one of the other layers may be formed of hafnium oxide.

In one embodiment, the light transmission member may have a flat upper surface and a flat lower surface.

In another embodiment, the light transmission member may have a dome structure with an upwardly convex upper surface.

### [Advantageous Effects]

The light emitting package according to embodiments of the present invention can improve reliability using sapphire that is not easily damaged by external impact.

In addition, the light emitting package according to embodiments of the present invention can improve light extraction efficiency through a light loss prevention layer formed on a sapphire layer.

### [Description of Drawings]

The accompanying drawings included and incorporated herein and made a part hereof to provide a further understanding of the invention illustrate embodiments of the invention and serve to illustrate the concept of the invention in conjunction with the detailed description.
FIG. 1 is a cross-sectional view of a light emitting package according to a first embodiment of the present invention.
FIG. 2 is a cross-sectional view of a light emitting package according to a second embodiment of the present invention.
FIG. 3 is a cross-sectional view of a light emitting package according to a third embodiment of the present invention.
FIG. 4 is a cross-sectional view of a light emitting package according to a fourth embodiment of the present invention.
FIG. 5 is a cross-sectional view of a light emitting package according to a fifth embodiment of the present invention.
FIG. 6 is a cross-sectional view of a light emitting package according to a sixth embodiment of the present invention.
FIG. 7 is a cross-sectional view of a light emitting package according to a seventh embodiment of the present invention.

### [Best Mode]

Hereinafter, embodiments of the present invention will be described with reference to the accompanying drawings. It should be understood that the following embodiments are provided for complete disclosure and thorough understanding of the present invention by those skilled in the art. Therefore, the present invention is not limited to the following embodiments and may be embodied in different ways. In addition, the drawings may be exaggerated in width, length, and thickness of components for descriptive convenience and clarity only. Like components will be denoted by like reference numerals throughout the specification.

Hereinafter, light emitting packages according to the present invention will be described in detail with reference to the accompanying drawings.

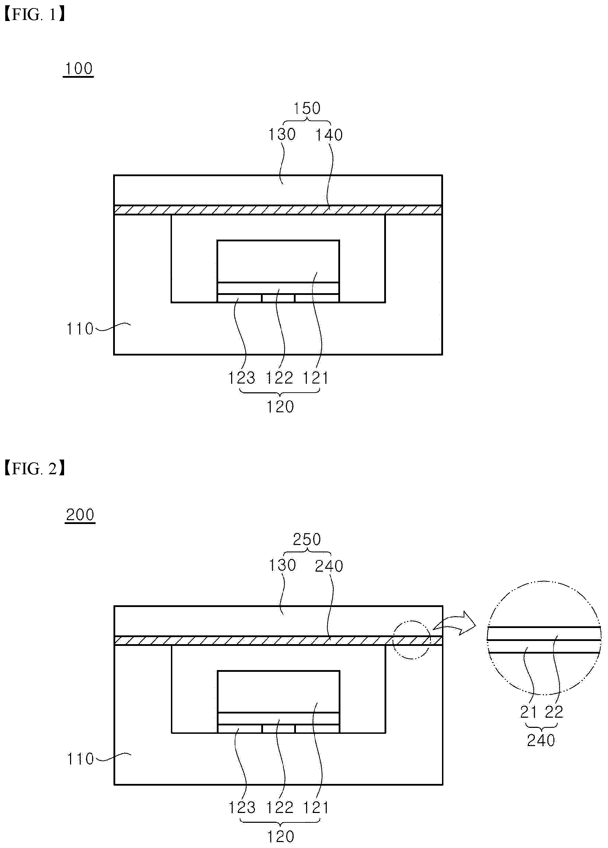

FIG. 1 is a cross-sectional view of a light emitting package according to a first embodiment of the present invention.

Referring to FIG. 1, the light emitting package 100 according to the first embodiment includes a body 110, a light emitting diode chip 120, and a light transmission member 150.

The body 110 may be formed of an insulating material. For example, the body 110 may be formed of a ceramic material. The ceramic material may include a low temperature co-fired ceramic (LTCC) or a high temperature co-fired ceramic (HTCC). In addition, the body 110 may include an insulating member of a nitride or an oxide. Alternatively, the body 110 may include a metal nitride having higher thermal conductivity than the nitride or the oxide. For example, the body 110 may include at least one of SiO₂, SiₓO_{y}, Si₃N₄, SiₓN_{y}, SiOₓN_{y}, Al₂O₃, or AlN, and may include a metal nitride having a thermal conductivity of 140 W/mK or more.

The body 110 may be formed with a cavity open at an upper side thereof. The light emitting diode chip 120 is mounted in the cavity. Referring to FIG. 1, the cavity has a structure in which an inner wall is perpendicular to a bottom surface of the cavity. However, the inner wall of the cavity may be an inclined surface inclined at a certain angle relative to the bottom surface.

Although not shown in the drawings, the body 110 may be formed with a circuit including lead frames, electrodes, and the like made of a conductive material. A portion of the circuit may be electrically connected to the light emitting diode chip 120 within the body 110. For example, some portion of the circuit may be exposed on the bottom surface of the cavity of the body 110. The circuit exposed on the bottom surface of the cavity may be electrically connected to electrodes 123 of the light emitting diode chip 120 disposed in the cavity.

In addition, the other portion of the circuit may be exposed to the exterior of the body 110.

By such a circuit, the light emitting diode chip 120 may be electrically connected to components placed outside the light emitting package 100.

The light emitting diode chip 120 may emit light in the UV spectrum.

The light emitting diode chip 120 includes a growth substrate 121, a semiconductor structure 122, and the electrodes 123. Referring to FIG. 1, the light emitting diode chip 120 has the electrodes 123, the semiconductor structure 122, and the growth substrate 121 placed sequentially from the bottom.

The growth substrate 121 may be selected from any substrates as long as the substrate allows growth of the semiconductor structure 122 thereon. For example, the growth substrate 121 may include a sapphire substrate, a gallium nitride substrate, a SiC substrate, or the like.

The semiconductor structure 122 is formed on the growth substrate 121.

Although not shown in the drawings, the semiconductor structure 122 may include a first conductivity type semiconductor layer, an active layer, and a second conductivity type semiconductor layer.

The semiconductor structure 122 has a structure in which the first conductivity type semiconductor layer, the active layer, and the second conductivity type semiconductor layer are sequentially stacked on the growth substrate 121 in a downward direction or in an upward direction. In FIG. 1, the semiconductor structure 122 is placed on a lower surface of the growth substrate 121.

The first conductivity type semiconductor layer may be grown on the growth substrate 121. For example, the first conductivity type semiconductor layer may be an n-type semiconductor layer doped with impurities.

The active layer may be formed on the first conductivity type semiconductor layer. The active layer may have a single quantum well structure or a multi-quantum well structure.

The composition and thickness of the well layer within the active layer may determine the wavelength of light generated therein. In this embodiment, the active layer may generate UV light based on the composition and thickness of the well layer.

The second conductivity type semiconductor layer is formed on the active layer. For example, the second conductivity type semiconductor layer may be a p-type semiconductor layer doped with impurities.

The semiconductor structure 122 may further include a reflective layer for improving luminous efficacy, an insulating layer for insulating each layer, and the like in addition to the first conductivity type semiconductor layer, the active layer, and the second conductivity type semiconductor layer for generating UV light.

Although the detailed structure of the semiconductor structure 122 is omitted in FIG. 1, the semiconductor structure 122 may have any structure that generates and emits light.

The light emitting diode chip may include a pair of electrodes 123.

A portion of one electrode 123 may be electrically connected to the first conductivity type semiconductor layer of the semiconductor structure 122. Another portion of the electrode 123 may be electrically connected to a portion of the circuit exposed to the cavity of the body 110.

In addition, a portion of the other electrode 123 may be electrically connected to the second conductivity type semiconductor layer of the semiconductor structure 122. Another portion of the other electrode 123 may be electrically connected to another portion of the circuit exposed to the cavity of the body 110.

In this way, the light emitting diode chip 120 may be electrically connected to the circuit of the body 110 by the electrodes 123.

When power is supplied to the light emitting diode chip 120 through the circuit, UV light is generated in the semiconductor structure 122. The UV light generated in the semiconductor structure 122 may be emitted from the light emitting diode chip 120 through the growth substrate 121.

Here, the UV light emitted from an upper surface of the light emitting diode chip 120 is directed towards the light transmission member 150. The upper surface of the light emitting diode chip 120 is an upper surface of the growth substrate 121.

In addition, UV light emitted from a side surface or a lower surface of the light emitting diode chip 120 may be reflected by the inner wall of the body 110 defining the cavity to be directed towards the light transmission member 150.

The light transmission member 150 may be disposed on an upper surface of the body 110 to cover the cavity.

In one embodiment, the light emitting package 100 may cover the cavity by disposing the light transmission member 150 on the upper surface of the body 110 without filling the cavity with a light transmitting resin. In another embodiment, the light emitting package 100 may cover the cavity by filling the cavity with the light transmitting resin and disposing the light transmission member 150 on the upper surface of the body 110.

The light transmission member 150 is formed of a material through which UV light emitted from the light emitting diode chip 120 can be transmitted.

According to an embodiment of the present invention, the light transmission member 150 may include a light transmission layer 130 and a light loss prevention layer 140.

Typically, quartz or silicone is used as materials for light transmission members.

A light transmission member formed of silicone exhibits low UV light transmittance, causing very low luminous efficacy of the light emitting package. A light transmission member formed of quartz exhibits high UV light transmittance, but has a disadvantage of increase in manufacturing costs of the light emitting package due to high price of quartz as a raw material. In addition, quartz has low hardness and can be easily broken by impact, thereby causing low reliability of the light emitting package.

The light transmission layer 130 of the light transmission member 150 according to the embodiment of the present invention is formed of sapphire.

Sapphire has higher strength than quartz. Thus, the light transmission layer 130 formed of sapphire is not easily broken by external impact, thereby securing high reliability of the light emitting package.

According to the embodiment of the invention, the light loss prevention layer 140 is formed on a lower surface of the light transmission layer 130.

The light loss prevention layer 140 may be formed of a material that is light transmissive while inhibiting light emitted from the light emitting diode chip 120 from being reflected by the light transmission layer 130.

Referring to FIG. 1, the light loss prevention layer 140 may be composed of a single layer.

For example, the light loss prevention layer 140 may be formed of magnesium fluoride (MgF₂) or hafnium oxide (HfO₂).

According to an embodiment of the invention, the light loss prevention layer 140 may be formed to a thickness of about 25 nm to about 50 nm. Here, as the wavelength of the UV light emitted from the light emitting diode chip 120 is reduced, the thickness of the light loss prevention layer 140 may also be reduced. For example, if the UV light of the light emitting diode chip 120 is UVC or UVB, the light loss prevention layer 140 may be formed to a thickness of about 25 nm to about 40 nm. In addition, if the UV light of the light emitting diode chip 120 is UVA, the light loss prevention layer 140 may be formed to a thickness of about 40 nm to about 50 nm.

In general, sapphire is known to be stronger than quartz, but less transmissive with respect to UV light.

However, in this embodiment, UV light transmittance of the light transmission member 150 can be improved by coating the light transmission layer 130 formed of sapphire with the light loss prevention layer 140 that suppresses light reflection.

As such, the light emitting package 100 according to the embodiment of the invention can have high reliability and high light extraction efficiency due to the light transmission member 150 formed by coating the light transmission layer 130 formed of sapphire with the light loss prevention layer 140 that suppresses light reflection.

The light emitting package 100 according to the embodiment of the invention may have a structure in which a ceramic layer, a metal layer, a UV light generation layer, an air layer, the light loss prevention layer 140, and a sapphire layer are placed sequentially in the upward direction from the bottom. Here, the ceramic layer is the body 110 and the metal layer is the electrodes 123 of the light emitting diode chip 120. Further, the UV light generation layer is a light emitting surface of the light emitting structure of the light emitting diode chip 120. In other words, the UV light generation layer may be the growth substrate 121 of the light emitting structure. The air layer is a space between the growth substrate 121 and the light loss prevention layer 140. Further, the sapphire layer is the light transmission layer 130 of the light transmission member 150.

Thus, the light emitting package 100 may have a structure in which UV light generated in the semiconductor structure 122 of the light emitting diode chip 120 sequentially passes through the growth substrate, the air layer, the light loss prevention layer 140, and the sapphire layer to be emitted outside.

That is, UV light generated in the light emitting diode chip 120 passes through a plurality of layers with different indexes of refraction.

With the structure including the plurality of layers having different indexes of refraction on a UV light path, the light emitting package 100 according to the embodiment of the invention can further improve light extraction efficiency.

Although the light loss prevention layer 140 is formed on the lower surface of the light transmission layer 130 in FIG. 1, it should be understood that the structure of the light transmission member 150 according to the present invention is not limited thereto. Alternatively, the light loss prevention layer 140 may be formed on the upper surface of the light transmission layer 130.

Hereinafter, light emitting packages according to other embodiments of the invention will be described mainly in terms of different features from the light emitting package according to the above embodiment. That is, for the light emitting packages according to the other embodiments, description of the same configuration as the configuration of the light emitting package of the above embodiment will be briefly described or omitted. Therefore, for detailed description of the same configuration, refer to the description of the above embodiment.

FIG. 2 is a cross-sectional view of a light emitting package according to a second embodiment of the present invention.

Referring to FIG. 2, the light emitting package 200 according to the second embodiment may include a body 110, a light emitting diode chip 120, and a light transmission member 250.

According to the second embodiment, the light transmission member 250 may include a light loss prevention layer 240 composed of a plurality of layers.

Referring to FIG. 2, the light loss prevention layer 240 has a bilayer structure that includes a first light loss prevention layer 21 and a second light loss prevention layer 22. Here, the first light loss prevention layer 21 and the second light loss prevention layer 22 may be formed from different materials.

For example, the first light loss prevention layer 21 may be formed of magnesium fluoride. In addition, the second light loss prevention layer 22 may be formed of hafnium oxide.

Although this embodiment illustrates the light loss prevention layer 240 having a bilayer structure, the light loss prevention layer 240 may include three or more layers.

Although each layer constituting the light loss prevention layer 240 in this embodiment is formed of a different material, the structure of the light loss prevention layer 240 is not limited thereto. That is, the light loss prevention layer 240 may be formed to have a plurality of layers formed of the same material.

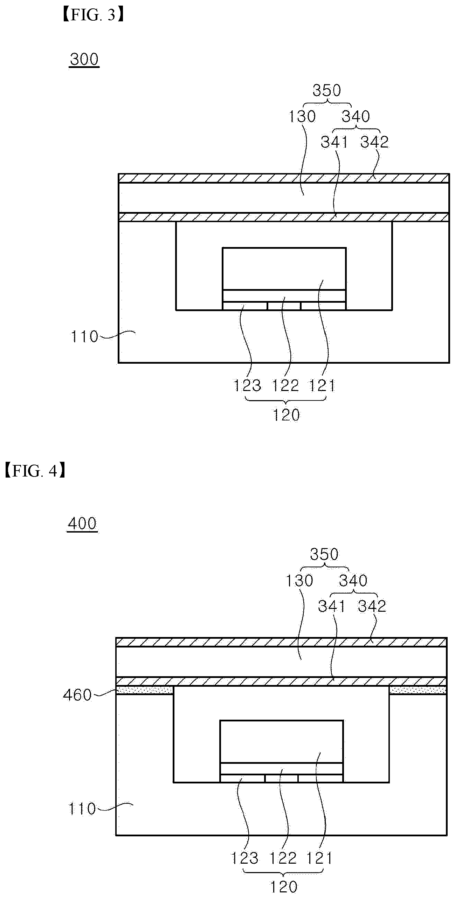

FIG. 3 is a cross-sectional view of a light emitting package according to a third embodiment of the present invention.

Referring to FIG. 3, the light emitting package 300 according to the third embodiment includes a body 110, a light emitting diode chip 120, and a light transmission member 350.

The light transmission member 350 may include a light transmission layer 130 formed of sapphire and a light loss prevention layer 340.

In addition, the light loss prevention layer 340 may include a lower light loss prevention layer 341 formed on a lower surface of the light transmission layer 130 and an upper light loss prevention layer 342 formed on an upper surface of the light transmission layer 130.

For the structures and materials of the lower light loss prevention layer 341 and the upper light loss prevention layer 342, refer to the description of the light loss prevention layer 340 of the light emitting package in FIG. 1 and FIG. 2.

The lower light loss prevention layer 341 and the upper light loss prevention layer 342 may have the same structure and material or may have different structures and materials.

The light emitting package 300 according to the third embodiment may have a structure in which the ceramic layer, the metal layer, the UV light generation layer, the air layer, the lower light loss prevention layer 341, the sapphire layer, and the upper light loss prevention layer 342 are placed sequentially in the upward direction from the bottom.

FIG. 4 is a cross-sectional view of a light emitting package according to a fourth embodiment of the present invention.

The light emitting package 400 according to the fourth embodiment may include a body 110, a light emitting diode chip 120, a light transmission member 350, and an adhesive member 460.

The light loss prevention layer 340 formed on the lower surface of the light transmission layer 130 may have low adhesion to a ceramic material.

In other words, adhesion between the lower light loss prevention layer 341 and the body 110 formed of the ceramic material may be low.

The light emitting package 400 according to this embodiment may further include the adhesive member 460 to compensate for low adhesion between the light transmission member 350 and the body 110.

Referring to FIG. 4, the adhesive member 460 is formed between the body 110 and the light transmission member 350.

For example, the adhesive member 460 may be formed of silica (SiO2) or strontium (Sr4).

Thus, the light emitting package 400 of this embodiment may have a structure in which an outer portion of the cavity has the ceramic layer, the adhesive layer, the light loss prevention layer 340, and the sapphire layer sequentially stacked one above another.

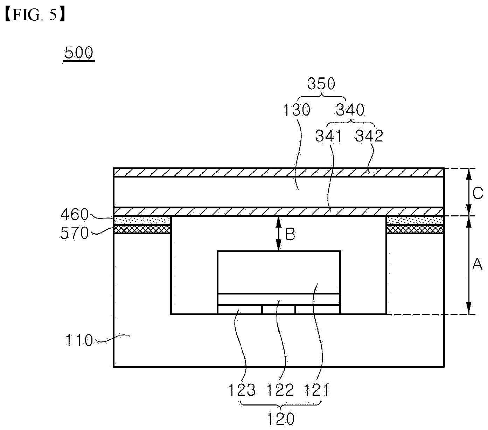

FIG. 5 is a cross-sectional view of a light emitting package according to a fifth embodiment of the present invention.

The light emitting package according to the fifth embodiment may include a body 110, a light emitting diode chip 120, a light transmission member 150, an adhesive member 460, and a sealing member 570.

The sealing member 570 may be formed to secure hermetic sealing of the light emitting package 500.

Accordingly, the sealing member 570 may be formed on the upper surface of the body 110.

Referring to FIG. 5, the sealing member 570 is formed on the upper surface of the body 110 and is thus placed between the body 110 and the adhesive member 460.

In one embodiment, the sealing member 570 may be formed on the upper surface of the body 110 through metallization.

For example, the sealing member 570 may be formed of gold (Au) or nickel (Ni). In addition, the sealing member 570 may include both a layer formed of gold and a layer formed of nickel.

Accordingly, the light emitting package 500 according to this embodiment may have a structure in which the outer portion of the cavity has the ceramic layer, the metal layer, the adhesive layer, the light loss prevention layer 340, and the sapphire layer sequentially stacked one above another. Here, the metal layer is the sealing member 570.

According to embodiments of the invention, the size of some configurations of the light emitting package 500 may vary depending on the wavelength of UV light emitted from the light emitting diode chip 120.

When the UV light emitted from the light emitting diode chip 120 is UVC, the overall thickness A of the air layer may be about 500 µm. That is, with reference to FIG. 5, the distance between the bottom surface of the cavity of the body 110 and the lower surface of the light transmission member 350 may be about 500 µm.

In addition, the air layer may have a minimum thickness B of about 100 µm. That is, the distance between the upper surface of the light emitting diode chip 120 corresponding to the light emitting surface of the light emitting diode chip 120 and the lower surface of the light transmission member 350 may be about 100 µm.

If UV light emitted from the light emitting diode chip 120 has a shorter wavelength than UVC, the overall thickness A of the air layer may be about 400 µm.

Further, the air layer may have a minimum thickness B of about 280 µm.

Here, the UV light having a shorter wavelength than UVC may be UVB, UVA, and near-UV light.

Further, according to the embodiment of the invention, the light transmission member 350 may have a thickness C of about 250 µm, regardless of the type of UV light emitted from the light emitting diode chip 120.

Table 1 below shows measurement results of light characteristics W of a typical light emitting package and the light emitting package 300 according to the third embodiment.

Here, the typical light emitting package is a light emitting package that includes a light transmission member formed of quartz. In Table 1, UV light is UV light in the wavelength range including the following peak wavelengths.

In addition, the measurement results of light characteristics in Table 1 are obtained by measuring the radiat flux W (J/s) which is light energy generated in each of the light emitting packages per unit time.

**Table 1**

| UV light | 275 nm | 365 nm | 385 nm | 395 nm | 405 nm |
|---|---|---|---|---|---|
| Typical light emitting package (W) | 11.07 | 0.9676 | 1.1595 | 1.2091 | 1.1818 |
| Light emitting package W according to third embodiment | 11.10 | 0.9764 | 1.1700 | 1.2268 | 1.1916 |

Referring to Table 1, in each UV light wavelength band, the light characteristics of the typical light emitting package are substantially similar to those of the light emitting package 300 according to the third embodiment.

From this result, it can be seen that the light transmission member 350 including the light loss prevention layer 340 on the light transmission layer 130 formed of sapphire exhibits similar light extraction efficiency to the light transmission member formed of quartz.

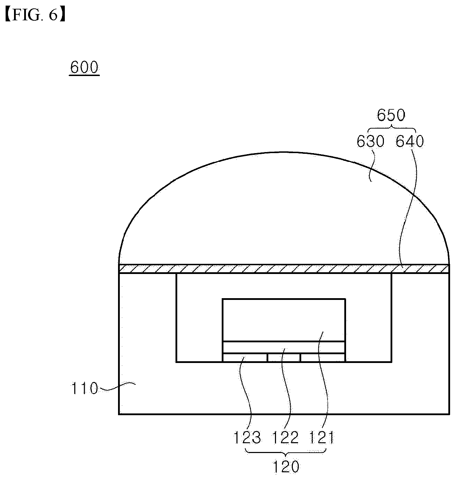

FIG. 6 is a cross-sectional view of a light emitting package according to a sixth embodiment of the present invention.

According to the sixth embodiment, the light emitting package 600 may include a body 110, a light emitting diode chip 120, and a light transmission member 650.

Referring to FIG. 6, the light transmission layer 630 of the light transmission member 650 is formed in a dome shape.

Further, the light loss prevention layer 640 is formed on the lower surface of the light transmission layer 630.

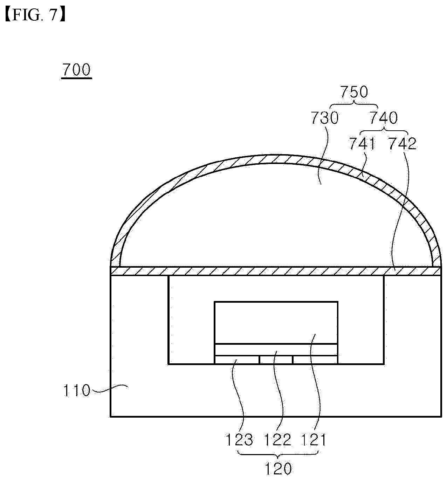

FIG. 7 is a cross-sectional view of a light emitting package according to a seventh embodiment of the present invention.

According to the seventh embodiment, the light emitting package 700 may include a body 110, a light emitting diode chip 120, and a light transmission member 750.

Referring to FIG. 7, the light transmission layer 730 of the light transmission member 750 is formed in a dome shape.

In addition, the light loss prevention layer 740 may include a lower light loss prevention layer 741 and an upper light loss prevention layer 742. The lower light loss prevention layer 741 is formed on a lower surface of the light transmission layer 730, and the upper light loss prevention layer 742 is formed on the upper surface of the light transmission layer 7130.

In FIG. 6 and FIG. 7, both light transmission layers 630, 730 have flat lower surfaces. That is, the light transmission layers 630, 730 have a flat incident surface on which UV light is incident, without being limited thereto. The structures of the incident surfaces of the light transmission layers 630, 730 may be varied in various ways.

Table 2 below shows measurement results of light characteristics Po (retention, %) of the light emitting package 600 according to the sixth embodiment and the light emitting package 700 according to the seventh embodiment.

Here, a typical light emitting package is a light emitting package in which the light transmission member does not include a light loss prevention layer and is formed as a dome-shaped light transmission layer. In Table 2, UV light is UV light in the wavelength band including the following peak wavelengths.

Further, in Table 2, the measurement results of light characteristics are the ratio of the radiant flux of each light emitting package to the radiant flux of the light emitting package not including the light transmission layer. That is, the light characteristic value of each light emitting package in Table 2 is calculated under the assumption that the radiant flux of the light emitting package not including the light transmission layer is 100%.

**Table 2**

| UV light | 365 nm | 385 nm | 395 nm | 405 nm |
|---|---|---|---|---|
| Typical light emitting package | 91.8 | 91.9 | 92.3 | 92.3 |
| Light emitting package according to sixth embodiment | 94.0 | 93.3 | 92.7 | 92.3 |
| Light emitting package according to seventh embodiment | 94.8 | 93.6 | 93.2 | 92.7 |

Referring to Table 2, in each wavelength band of UV light, the light emitting package 700 of the seventh embodiment is higher than the light emitting package 600 of the sixth embodiment, but there is no significant difference therebetween.

In addition, the light emitting package 600 of the sixth embodiment and the light emitting package 700 of the seventh embodiment, in which the light loss prevention layer 640; 740 is formed on at least one surface of the light transmission layer 630; 730, exhibit better light characteristics than the light emitting package in which the light loss prevention layer is omitted.

Thus, it can be seen that luminous efficacy of the light emitting packages is improved by the light loss prevention layers 640, 740.

As such, according to the embodiments of the present invention, the light transmission member acting as a lens may be formed of sapphire, thereby improving reliability of the light emitting packages.

Furthermore, according to the embodiments of the present invention, the light loss prevention layer may be formed on at least one surface of the sapphire layer to improve light extraction efficiency of the light emitting package.

As such, the light emitting packages according to the embodiments of the present invention can simultaneously improve both reliability and luminous efficacy.

Although some embodiments have been described herein with reference to the accompanying drawings, it should be understood that the foregoing embodiments are provided for illustration only and are not to be in any way construed as limiting the technical idea of the present invention. The scope of the present invention should be defined by the appended claims and equivalents thereto.

## Claims

1. A light emitting package comprising:
a body formed of a ceramic material and having a cavity open at an upper side thereof;
a light emitting diode chip mounted in the cavity of the body and generating and emitting UV light; and
a light transmission member disposed on top of the body to cover the cavity;
wherein the light transmission member comprises a light transmission layer formed of sapphire and a light loss prevention layer formed on at least one surface of the light transmission layer,
the light loss prevention layer comprising a lower light loss prevention layer formed on a lower surface of the light transmission layer,
the light emitting diode chip and the light transmission member are spaced apart from each other to form a space therebetween, and
UV light emitted from the light emitting diode chip sequentially passes through an air layer, the lower light loss prevention layer and a sapphire layer so as to be emitted from the light emitting package.

2. The light emitting package according to claim 1, wherein the body comprises a circuit formed therein, and the circuit is partially exposed to the cavity of the body and is electrically connected to the light emitting diode chip.

3. The light emitting package according to claim 2, wherein the light emitting diode chip comprises an electrode formed of a conductive metallic material at a lower side thereof, and the electrode of the light emitting diode chip is electrically connected to the circuit exposed to the cavity of the body.

4. The light emitting package according to claim 3, wherein the light emitting package has a structure in which a ceramic layer, a metal layer, a UV light generation layer, the air layer, the light loss prevention layer, and the sapphire layer are placed sequentially from the bottom to the top.

5. The light emitting package according to claim 3, wherein the lower light loss prevention layer has a single-layer structure.

6. The light emitting package according to claim 3, wherein the lower light loss prevention layer is formed of magnesium fluoride (MgF₂).

7. The light emitting package according to claim 3, wherein the lower light loss prevention layer comprises a plurality of layers.

8. The light emitting package according to claim 7, wherein at least one layer of the plurality of layers of the lower light loss prevention layer is formed of magnesium fluoride (MgF₂) and at least one of the other layers is formed of hafnium oxide.

9. The light emitting package according to claim 1, further comprising: an adhesive member disposed between the body and the light transmission member.

10. The light emitting package according to claim 9, wherein the adhesive member is formed of silica (SiO₂) or strontium (Sr₄).

11. The light emitting package according to claim 1, further comprising: a sealing member formed on an upper surface of the body.

12. The light emitting package according to claim 11, wherein the sealing member is formed through metallization.

13. The light emitting package according to claim 3, wherein the light transmission member further comprises an upper light loss prevention layer formed on an upper surface of the light transmission layer.

14. The light emitting package according to claim 13, wherein the upper light loss prevention layer has a single-layer structure.

15. The light emitting package according to claim 14, wherein the upper light loss prevention layer is formed of magnesium fluoride (MgF₂).

16. The light emitting package according to claim 13, wherein the upper light loss prevention layer comprises a plurality of layers.

17. The light emitting package according to claim 16, wherein at least one of the plurality of layers of the upper light loss prevention layer is formed of magnesium fluoride (MgF₂) and at least one of the other layers is formed of hafnium oxide.

18. The light emitting package according to claim 1, wherein the light transmission member has a flat upper surface and a flat lower surface.

19. The light emitting package according to claim 1, wherein the light transmission member has a dome structure with an upwardly convex upper surface.
